(19) **Europäisches Patentamt / European Patent Office / Office européen des brevets**

(11) **EP 1 956 714 B1**

(12) **FASCICULE DE BREVET EUROPEEN**

(45) Date de publication et mention
de la délivrance du brevet:
**28.07.2010 Bulletin 2010/30**

(51) Int Cl.:
*H03L 7/091* (2006.01)     *H03M 1/50* (2006.01)

(21) Numéro de dépôt: **08368003.3**

(22) Date de dépôt: **07.02.2008**

(54) **Procédé d'ajout d'un bruit aléatoire dans un circuit convertisseur temps-numérique et circuits pour mettre en oeuvre le procédé**

Verfahren zum Hinzufügen eines zufallsbedingten Rauschens in einen Zeit-Digital-Wandlungsschaltkreis und Schaltkreise zur Umsetzung des Verfahrens

Method for adding random noise in a time-to-digital converter circuit and circuits for implementing the method

(84) Etats contractants désignés:
**DE FR GB IT**

(30) Priorité: **08.02.2007 FR 0700889**

(43) Date de publication de la demande:
**13.08.2008 Bulletin 2008/33**

(73) Titulaire: **STMicroelectronics SA**
**92120 Montrouge (FR)**

(72) Inventeurs:
 • **Baudin, Pierre**
 **38000 Grenoble (FR)**

 • **Joubert, Cyril**
 **38000 Grenoble (FR)**

(74) Mandataire: **Schuffenecker, Thierry**
**120 Chemin de la Maure**
**06800 Cagnes sur Mer (FR)**

(56) Documents cités:
 **EP-A- 1 443 653**     **US-A1- 2005 195 917**
 **US-A1- 2006 103 566**

**Description**

**Domaine technique de l'invention**

La présente invention concerne les procédés et circuits de synthèse de fréquence, et plus spécialement un procédé d'ajout d'un bruit aléatoire dans un convertisseur de type temps-numérique (TDC )

**Etat de la technique**

Les circuits électroniques de synthèse de fréquence sont particulièrement utilisés dans les architectures de circuits électroniques et spécifiquement dans le domaine des télécommunications .

De manière classique, le problème consister à générer un signal sinusoïdal présentant une fréquence égale à n fois une fréquence de référence supposée stable, par exemple celle d'un oscillateur à quartz.

Dans une telle situation, la synthèse de fréquence est réalisée au moyen d'un circuit à verrouillage de phase de type P.L.L (*Phase Locked Loop* dans la littérature anglo-saxonne) et, récemment, la tendance est allée vers une généralisation des architectures complètement numériques.

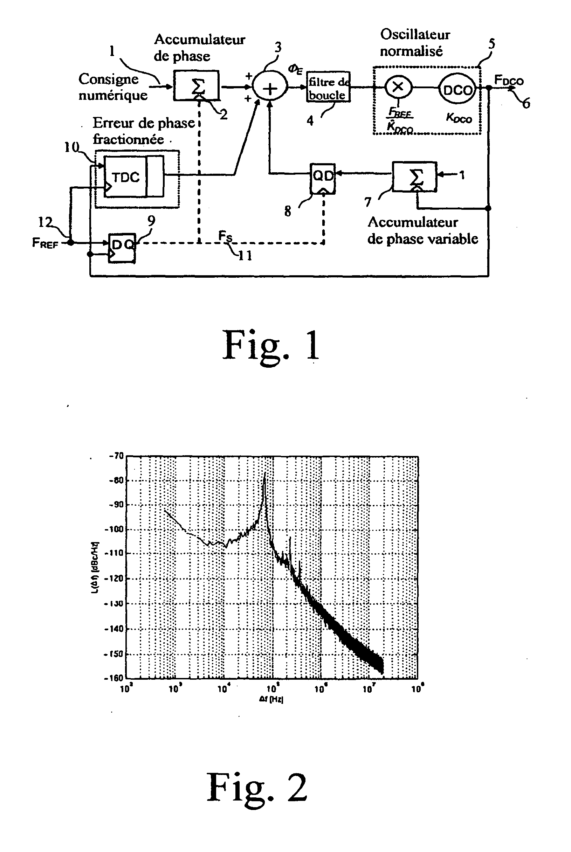

La figure 1 illustre une architecture numérique connue d'un circuit de synthèse de fréquence permettant de générer sur une sortie 6 un signal haute fréquence $F_{DCO}$ à partir d'une fréquence de référence $F_{REF}$, idéalement générée par un oscillateur à quartz introduite sur une entrée 12.

Le circuit de synthèse utilise une horloge synchrone Fs présente dans le circuit, et qui est générée à partir d'une bascule dont les entrées D et horloge reçoivent respectivement le signal de référence $F_{ref}$ et le signal de sortie $F_{DCO}$.

Un mot numérique représentatif d'une consigne est introduite sur une entrée 1 d'une chaîne de traitement numérique comportant, en série, un accumulateur de phase 2, un additionneur 3 générant un signal d'erreur $\Phi_E$, un filtre de boucle 4 suivi d'un oscillateur normalisé 5 générant sur une sortie 6 le signal haute fréquence $F_{DCO}$.

L'asservissement en fréquence et en phase de ce signal $F_{DCO}$ est réalisé au moyen de deux boudes de contre-réaction traitant respectivement de la partie entière et de la partie fractionnée, du ratio n souhaité entre la fréquence de sortie $F_{DCO}$ et la fréquence de référence $F_{ref}$.

Le traitement de la partie entière est réalisé au moyen d'une première boucle de contre-réaction basée sur un accumulateur 7 et sa bascule de sous-échantillonnage 8 rythmée par l'horloge interne Fs, lesquelles permettent l'accumulation des fronts montants de $F_{DCO}$ entre deux fronts de la référence $F_{ref}$.

Le traitement de la partie fractionnée du ratio n est réalisé au moyen d'une seconde boucle de contre-réaction comportant un circuit d'erreur de phase fractionnée 10, classiquement dénommé « *Time to Digital Converter* » (TDC) dans la littérature anglo-saxonne. Ce circuit TDC dispose de deux entrées recevant respectivement l'horloge de référence $F_{ref}$ et l'horloge synthétisée $F_{DCO}$ et génère en sortie un mot numérique qui est représentatif de l'écart de phase entre les fronts du signal de référence et les fronts de l'oscillateur 5. La sortie de ce circuit d'erreur de phase fractionnel est transmise à l'additionneur 3 pour contribuer au signal d'erreur $\Phi_E$.

C'est typiquement une application classique d'un circuit TDC.

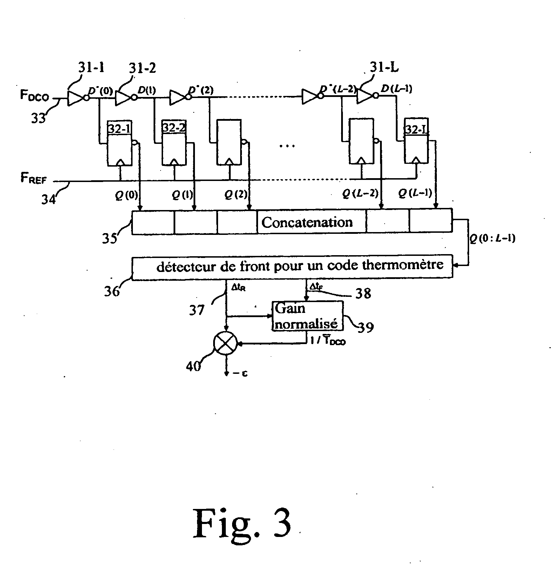

La figure 3 illustre une réalisation bien connue d'un circuit TDC, comportant une chaîne de retards - typiquement basées sur des inverseurs 31-1 à 31-L - (L étant un entier représentant le nombre d'éléments inverseurs dans la chaîne) présentant chacun une sortie connectée à une entrée d'une bascule correspondante 32-1 à 32-L. La chaîne de retard est conçue de manière à couvrir toute une période du signal haute fréquence $F_{DCO}$ et chacune des bascules 31-1 à 31-L reçoit sur son entrée horloge le signal de référence Fret.

Les sorties des bascules 32-1 à 32-L sont concaténées de manière à former un vecteur codé suivant un code classiquement désigné sous l'appellation « thermomètre », lequel permet de faire apparaître les transitions entre les états « 1 » et les états « 0 ». Ce code est analysé par un circuit générateur de fronts permettant de générer les valeurs d'écart entre les fronts montants ($\Delta tr$) et descendants ( $\Delta tf$ ) , respectivement sur les circuits 37 et 38, transmis à un circuit de gain normalisé 39 permettant de générer la valeur 1/ $T_{DCO}$ permettant le calcul de l'écart de phase :

$$\varepsilon = 1 - \frac{\Delta t_R}{T_{DCO}} = 1 - \frac{\Delta t_R}{2|\Delta t_R - \Delta t_F|}$$

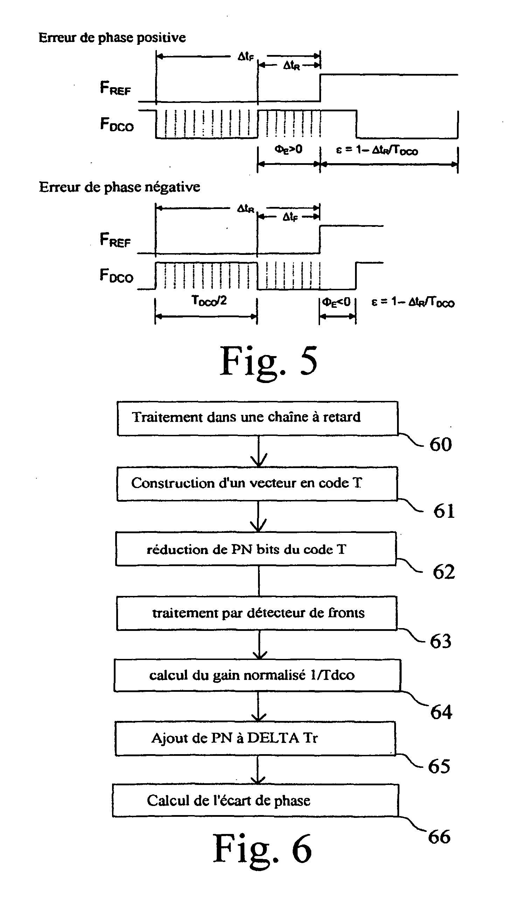

et, en appliquant les conventions apparaissant sur les chronogrammes de la figure 5, la valeur moyenne de la période $T_{DCO}$ peut être calculée comme suit :

$$\overline{T}_{DCO} = \frac{1}{N_{AVG}} \sum_{k=1}^{N_{AVG}} 2|\Delta t_R - \Delta t_F| \approx \frac{T_{DCO}}{t_{inv}}$$

L'architecture de synthèse de fréquence qui vient d'être brièvement rappelée illustre une implémentation complètement numérique, dont l'asservissement PLL est réalisée principalement par le circuit de type TDC réalisant le traitement de l'erreur de phase fractionnée 10.

Cette implémentation complète numérique souffre cependant d'un problème lié à la présence de cycles limites dans le spectre de bruit, tel qu'il est illustré dans la figure 2.

Le problème des cycles limites résultent des limites de résolution de l'oscillateur 5 lié au pas de quantification utilisé dans la synthèse numérique. En raison de ce pas de quantification, lequel détermine la précision de la résolution de l'oscillateur, ce dernier ne peut générer que deux fréquences voisines séparées par le pas de quantification, mais certainement pas des fréquences intermédiaires entre ces deux fréquences voisines.

Une fois l'asservissement opérationnel, il en résulte alors un fonctionnement qui présente un « battement » , c'est à dire une alternance de fréquences voisines au niveau de la fréquence synthétisée et ce battement fait apparaître les raies parasites que l'on observe sur la figure 2, lesquelles raies sont sources d'un bruit de quantification important.

On observe que les raies sont particulièrement présentes lorsque la fréquence de sortie $F_{DCO}$ est un multiple entier de la fréquence $F_{ref}$. Dans ces conditions, on observe que l'effet des cycles limites est maximum ce qui conduit à un bruit de quantification non satisfaisant.

Pour réduire ce bruit de quantification, ou plus précisément pour atténuer la présence de ces raies, on utilise des techniques bien connues d'ajout de bruit aléatoire pour disperser le bruit de quantification et tenter de supprimer - ou du moins d'atténuer fortement - les raies parasites... On se rapproche alors des caractéristiques de celles d'un bruit blanc. Ces techniques d'ajout de bruit aléatoire sont classiquement désignées dans la littérature anglo-saxonne sous l'appellation *« dithering »*.

D'une manière générale, les techniques connues d'ajout de bruit aléatoire sont complexes à mettre en oeuvre et requièrent des circuits venant alourdir de manière significative la simplicité de l'architecture numérique.

On en trouve des exemples dans les références suivantes :

Le document "All-Digital Phase-Domain TX Frequency Synthesizer for Bluetooth Radios in 0.13pm CMIOS" de Staszewski et al, IEEE INTERNATIONAL SOLID STATE CIRCUITS CONFERENCE, 2004, Session 15, 272-273, décrit une première implémentation d'un circuit TDC connu.

La demande de brevet américaine US Serial application No.: 306655, déposée le 27 Novembre 2002 par Staszewski et al, décrit ainsi une architecture de synthèse de fréquence complètement numérique basée sur un oscillateur commandé numériquement (DCO) qui est ajusté au moyen d'un mot de commande numérique (OTW).

La demande de brevet déposé le 6 Octobre 2003, sous le numéro d'application 20040066240, par Staszewski et al, décrit également une synthèse de fréquence basée sur un oscillateur commandé numériquement.

Ces solutions connues visent à introduire un décalage aléatoire au niveau des fronts montant du signal de référence $F_{ref}$ , de manière à ajouter un bruit aléatoire. En revanche, les implémentations sont complexes et notamment requièrent des modifications significatives au niveau de chacun des éléments du circuit de synthèse.

Le document US 2006 103566 A1 décrit un circuit de détection de phase à haute résolution pour un processeur RF digital.

Il est souhaitable de pouvoir disposer d'une solution plus simple à mettre en oeuvre, permettant notamment l'intégration d'une technique de « dithering » directement au sein du convertisseur TDC, de manière à conserver une simplicité d'architecture pour le circuit de synthèse de fréquence.

La présente invention a pour objet de proposer une implémentation simple d'un procédé de dispersion (*dithering*) directement au sein d'un convertisseur TDC

**Exposé de l'invention**

La présente invention a pour but de proposer un circuit convertisseur de type TDC comportant un mécanisme d'ajout de bruit aléatoire complètement intégré.

Un autre but de la présente invention consiste à proposer un circuit de synthèse de fréquence, simple à réaliser, comportant un mécanisme d'ajout de bruit aléatoire pour réaliser une dispersion du bruit de quantification.

C'est un autre but de la présente invention que de fournir un circuit de synthèse de fréquence bon marché pour un équipement de télécommunications.

L'invention réalise ces buts au moyen d'un procédé d'ajout d'un bruit aléatoire dans un circuit convertisseur temps-numérique destiné à calculer l'écart de phase entre un premier signal rapide $F_{DCO}$ relativement à un second signal de référence $F_{ref}$ plus lent.

Le procédé comporte les étapes :

- traitement (60) du premier signal $F_{DCO}$ au moyen d'une chaîne à retard comportant un ensemble de n retard élémentaires dont le nombre est choisi de manière à couvrir une période complète dudit premier signal ;

- stockage (61) des sorties desdites chaînes à retard dans un ensemble de bascules et génération d'un code thermométrique présentant une succession de « 1 » séparé par une succession de « 0 », la transition entre les « 1 » et les « 0 » correspondant à la transition dudit premier signal par rapport audit second signal de référence ;

- réduction (62) dudit code thermométrique d'un nombre aléatoire de PN bits

- traitement (63) du résultat dans un détecteur de front et décodeur thermométrique binaire de manière à générer les variables $\Delta t_r$ et $\Delta t_f$ représentative de l'écart des temps de montée et de descente dudit premier signal par rapport audit second signal de référence ;

- calcul du gain normalisé (64) de manière à générer la valeur moyenne de $1/T_{DCO}$

- ajout (65) d'une valeur binaire correspondant au nombre de bits PN à la valeur $\Delta t_r$
- multiplication (66) du résultat précédent par la valeur moyenne de $1/T_{DCO}$ et calcul de l'écart de phase entre les signaux

De préférence, la chaîne à retard est réalisé au moyen d'inverseurs, mais alternativement des éléments de type «tampons» ou suiveurs pourront être utilisés.

L'invention permet également la réalisation d'un circuit convertisseur de type TDC comportant deux entrées recevant respectivement un premier signal rapide $F_{DCO}$ relativement à un second signal de référence $F_{ref}$, plus lent, et générant en sortie un mot numérique représentatif de l'écart de phase entre les deux signaux.

Le circuit convertisseur temps-numérique comporte :

- une ligne à retard formée par une chaîne de retards comportant un nombre d'éléments n supérieurs d'un montant Max(PN) à la longueur L nécessaire pour couvrir une période entière dudit premier signal ;
- un ensemble de bascules permettant chacune de stocker la sortie d'un élément correspondant de ladite chaîne à retard aux fins de génération d'un code thermométrique présentant une succession de « 1 » séparé par une succession de « 0 », la transition entre les « 1 » et les « 0 » correspondant à la transition dudit premier signal par rapport audit second signal de référence ;
- des moyens permettant de supprimer de manière aléatoire un nombre PN de bits, ledit nombre PN variant de 0 à MAX(PN) ;
- des moyens de détection de fronts et de décodage thermométrique binaire pour générer des informations numériques $\Delta t_r$ et $\Delta t_f$ respectivement représentatives des décalages des fronts montants et descendants entre lesdits premiers et second signaux ($F_{ref}$ et $F_{DCO}$) ;
- des moyens permettant de traiter les informations $\Delta t_r$ et $\Delta t_f$ pour calculer un gain normalisé et générer la valeur moyenne de l'inverse de la période $1/T_{DCO}$ dudit premier signal
- des moyens pour ajouter à $\Delta t_r$ une valeur binaire correspondant au nombre de bits PN supprimés ;
- des moyens pour multiplier les résultats précédents par la valeur moyenne de l'inverse de $1/T_{DCO}$ et générer une valeur numérique $\varepsilon$ représentative de l'écart de phase.

Le procédé et le circuit TDC sont particulièrement utiles à la réalisation d'un circuit de synthèse de fréquence comportant un convertisseur temps- numérique doté d'un mécanisme d'ajout de bruit aléatoire inhérent.

**Description des dessins**

D'autres caractéristiques, but et avantages de l'invention apparaîtront à la lecture de la description et des dessins ci-après, donnés uniquement à titre d'exemples non limitatifs. Sur les dessins annexés :

La figure 1 illustre une architecture connue d'un circuit de synthèse de fréquence complètement numérique.

La figure 2 illustre le phénomène de cycles limites.

La figure 3 illustre une réalisation classique d'un circuit de type TDC.

La figure 4 illustre un mode de réalisation préféré de l'invention.

La figure 5 illustre les chronogrammes l'horloge de référence $F_{ref}$ et l'horloge synthétisée $F_{DCO}$ dans le cas d'une avance et d'un retard de phase.

La figure 6 illustre le procédé d'insertion du bruit aléatoire conforme à la présente invention

La figure 7a illustre les courbes comparatives représentatives de linéarité et de sortie normalisée du convertisseur TDC, avec et sans l'utilisation du procédé de l'invention.

La figure 7b illustre les courbes comparatives de la sortie normalisé du convertisseur TDC , avec et sans l'utilisation du procédé de l'invention.

La figure 8 montre l'effet du procédé de l'invention sur le spectre du bruit de phase.

**Description d'un mode de réalisation préféré**

On décrit à présent un procédé simple permettant d'ajouter un bruit aléatoire dans le fonctionnement d'un circuit convertisseur de type TDC.

L'application envisagée, dans le mode de réalisation préféré est typiquement une application de synthèse de fréquence comme celles que l'on rencontre classiquement dans les circuits de télécommunication et notamment en télécommunications mobiles. Il est à noter , toutefois, qu'il ne s'agit que d'un mode de réalisation particulier et que le circuit convertisseur TDC que l'on décrit ci-après est utilisable dans un grand nombre d'autres applications.

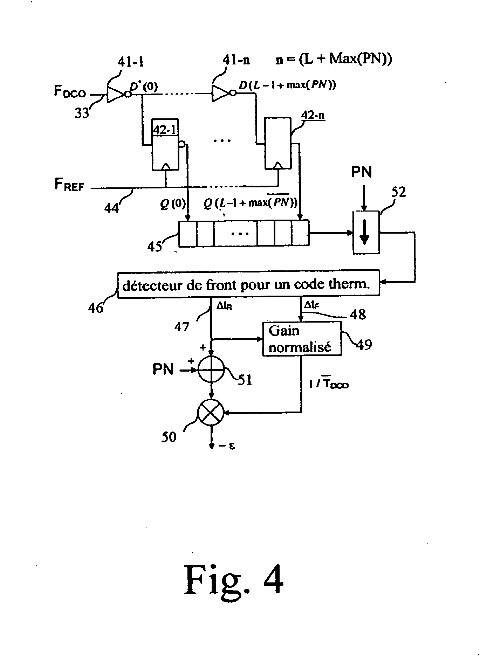

Le circuit convertisseur selon l'invention est illustré dans la figure 4 qui est , volontairement dans un souci de clarté, représentée d'une manière très similaire au circuit connu de la figure 3, afin de mieux mettre en évidence les éléments ajoutés et qui viennent améliorer de manière significative le fonctionnement du circuit.

Le circuit comporte une ligne à retard formée par une chaîne d'inverseurs 41-1 à 41-n comportant un nombre d'inverseurs plus élevé que dans le circuit connu de la figure 3. On aura donc

n > L , avec L choisi de manière à assurer que la ligne à retard formée de L éléments s'étend sur au moins une période du signal haute fréquence $F_{DCO}$

De manière plus précise, le nombre d'inverseurs supplémentaires (n - L) que l'on vient ajouter à la chaîne connue est fixé de manière à permettre l'extraction, au sein de la chaîne de longueur n, d'une « fenêtre » de longueur L, avec des possibilités multiples de variations aléatoires dans le procédé d'extraction.

On note également que les inverseurs 41-1 à 41-n pourront alternativement être des éléments tampons, ou « buffer » dans la littérature anglo-saxonne. L'homme du métier sait qu'un élément inverseur présente en général le délai de retard le plus court (car il ne nécessite que deux transistors au minimum) et, pour cette raison, on réalisera de préférence la chaîne de traitement 41-1 à 41-n au moyen d'éléments inverseurs.

La sortie de chacun des éléments inverseurs 41-1 à 41-n - à savoir D(0) à D(n) est connectée à une entrée d'une bascule de type D 42-1 à 42-n, chaque bascule recevant sur son entrée horloge la fréquence de référence $F_{Ref}$ .

En sortie, les bascules 41-1 à 41-n fournissent ainsi chacune un bit pour former un vecteur concaténé de longueur n qui est stocké dans un registre 45, similaire (à la longueur près au vecteur 35 de la figure 3). Ce vecteur prend la forme d'un code thermométrique présentant une succession de « 1 » séparé par une succession de « 0 », la transition entre les « 1 » et les «0» étant caractéristique de la transition de l'horloge synthétisée $F_{DCO}$.

Le procédé selon l'invention se distingue à présent du procédé qui était connu précédemment. En effet, un bloc 52 réalise une réduction de PN bits du mot concaténé dans le code thermométrique présent dans le registre 45. Dans un mode de réalisation préféré, cela est simplement effectué par la suppression des PN premiers bits , PN variant de manière aléatoire de 0 à Max(PN). On parvient ainsi à un mot de longueur au minimum égal à L, couvrant ainsi toute la période du signal $F_{DCO}$ .

On note que pour chaque suppression d'un bit, cela revient, en raison du codage thermométrique, à l'introduction d'un décalage de $\Delta t$.

Un autre mode de réalisation consisterait à insérer une mécanisme d'extraction d'une sous fenêtre, de longueur n - PN , au sein du vecteur de concaténation initial de longueur n.

Une fois que l'on a procédé à la « réduction » du mot contenu dans le registre 45, cette information est traitée par un bloc 46 qui opère d'une manière similaire au détecteur 36 du circuit connu de la figure 3. Ce bloc 46 effectue donc une détection de fronts, suivie d'un décodage thermométrique binaire, de manière à générer des valeurs numériques représentatives des variables $\Delta t_r$ (décalage entre les front montants - tr pour *rise time)*

et $\Delta t_f$ (décalage entre les fronts descendants ou *fall time)* entre les deux horloges $F_{ref}$ et $F_{DCO}$.

Ces variables $\Delta t_r$ et $\Delta t_f$ sont ensuite traitées par un bloc 49 permettant un calcul de gain normalisé similaire à celui effectué par le bloc 39 de la figure 3 , permettant de générer la valeur moyenne de 1/ $T_{DCO}$

Le bloc 51 réalise ensuite l'addition de la valeur binaire PN à la valeur de $\Delta t_r$ afin de compenser la réduction opérée par le bloc 52. On notera au passage qu'une réduction de quatre bits opérée par le bloc 52 devra être compensé par l'ajout de PN=4, codé sur 3 bits encode binaire. Le résultat de l'addition de PN est ensuite multiplié par le résultat de l'information fournie par le bloc 49.

L'ajout de PN par le bloc 51 permet de compenser - en théorie - exactement la réduction opérée sur le code thermométrique par le bloc 52. Mais cette compensation n'est que théorique en raison des erreurs d'arrondis introduites par le pas de quantification existant dans le système numérique.

On observe que les erreurs d'arrondis conduisent à l'ajout d'un bruit aléatoire de valeur inférieure au pas de quantification. On parvient ainsi, par le simple jeu de la manipulation opérée par les blocs 51 et 52, à introduire un décalage très fin d'un signal par rapport à un autre, à une valeur inférieure au pas de quantification intrinseque du TDC.

On obtient ainsi pratiquement le même résultat qu'une seconde chaîne de retard, basée sur des inverseurs présentant des retards élémentaires inférieurs au pas de quantification de la chaîne de retard principale 41-1 à 41-n.

C'est un avantage déterminant de ne pas avoir à utiliser une telle seconde chaîne de retard.

La figure 6 illustre les différentes phase du procédé conforme à la présente invention permettant l'ajout du bruit aléatoire directement au sein d'un convertisseur temps-numérique générant une information numérique représentative d'un écart de phase entre une horloge de référence $F_{ref}$ et une horloge synthétisée $F_{DCO}$

Le procédé débute par une étape 60 consistant à traiter le signal $F_{DCO}$ au moyen d'une chaîne à retard de longueur n comportant un ensemble de n retards élémentaires dont le nombre est choisi de manière à couvrir une période complète dudit premier signal.

Le procédé se poursuit ensuite par une étape 61 effectuant le stockage des sorties desdites chaînes à retard dans un ensemble de bascules, rythmées par l'horloge de référence $F_{ref}$ , en vue de la génération d'un code thermométrique présentant une succession de « 1 » séparé par une succession de « 0 », la transition entre les « 1 » et les « 0 » correspondant à la transition dudit premier signal par rapport audit second signal de référence.

Dans une étape 62, le procédé procède à une réduction aléatoire de PN bits du code thermométrique généré à l'étape 61.

Dans une étape 63, le code thermométrique résultant est transmis à un détecteur de fronts de manière à générer les variables $\Delta t_r$ et $\Delta t_f$ représentatives de l'écart de phase entre les deux horloges.

Du fait de la réduction de PN bits, le détecteur de front conduit à une variable variables $\Delta t_r{}^{dith}$ égale à :

$$\Delta t_R{}^{dith} = \left(\Delta t_R - PN\right)\mathrm{mod}\left[T_{DCO}/t_{inv}\right]$$

Dans une étape 64, le procédé effectue un calcul de gain normalisé à partir des deux variables $\Delta t_r$ et $\Delta t_f$ de manière à calculer la valeur moyenne de $1/T_{DCO}$.

Dans une étape 65, le procédé ajoute à nouveau PN à la variables $\Delta t_r$.

Dans une étape 66 le procédé calcule l'erreur de phase à partir du résultat des étapes 64 et 65 suivant la formule :

$$\varepsilon = 1 - \left(\frac{\Delta t_R{}^{dith} + PN}{\bar{\bar{T}}_{DCO}}\right)\mathrm{mod}[1]$$

La technique qui vient d'être décrite permet ainsi d'obtenir un effet significatif, équivalent à celui résultant d'une seconde chaîne à retard ayant un pas inférieur au pas principal, simplement en se basant sur la combinaison du décalage, du calcul du gain normalisé et l'ajout de PN à nouveau provoquent des erreurs de calculs - du fait de l'existence de la quantification - qui introduisent un élément de bruit particulièrement fait, comme si, d'une manière analogique, on avait introduit un décalage inférieur au pas de quantification.

On réussit ainsi, de manière très simple, à obtenir un effet de dispersion du bruit de quantification et la disparition, ou du moins une forte atténuation des raies parasites.

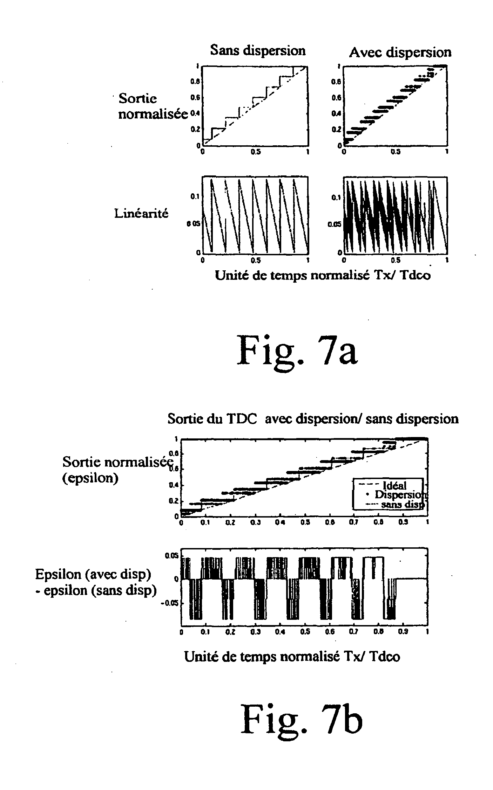

Les figures 7a et 7b illustrent l'effet du procédé selon l'invention. La figure 7a illustre les courbes comparatives représentatives de linéarité et de sortie normalisée du convertisseur TDC, avec et sans l'utilisation du procédé de l'invention. La figure 7b illustre les courbes comparatives de la sortie normalisé du convertisseur TDC, avec et sans l'utilisation du procédé de l'invention. On voit que l'on peut, grâce au procédé selon l'invention réaliser des pas de quantification intermédiaires.

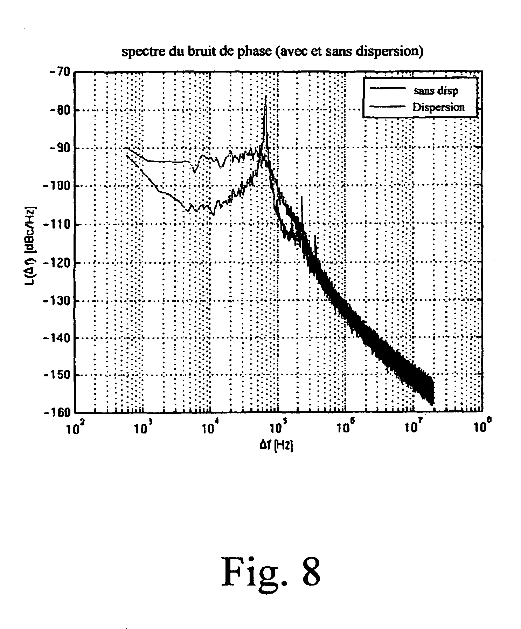

La figure 8 montre l'effet du procédé de l'invention sur le spectre du bruit de phase et l'on observe que l'on a réduit de manière significative la présence des raies parasites caractéristiques de cycles limites.

Le circuit convertisseur qui vient d'être exposé est particulièrement utile à la réalisation d'un circuit de synthèse de fréquence que l'on pourra exposer, dans un souci de clarté, en référence avec les éléments illustrés dans la figure 1. Il suffit, à cette fin, d'associer au circuit convertisseur temps-numérique que l'on vient d'exposer une chaîne de traitement numérique, similaire à la chaîne illustrée en figure 1, comportant, en série, un accumulateur de phase (2), un additionneur (3) générant un signal d'erreur $\Phi_E$, un filtre de boucle (4) et un oscillateur (5) générant sur une sortie 6 ledit signal haute fréquence $F_{DCO}$.

Pour traiter respectivement la partie entière et la partie fractionnée du ratio n souhaité entre la fréquence de sortie $F_{DCO}$ et la fréquence de référence $F_{ref}$, on adjoindra une première et une seconde boucle de contre-réaction, la première boucle étant similaire à celle existant dans le circuit connu de la figure 1.

La seconde boucle de contre-réaction comportera un circuit convertisseur temps - numérique comportant :

- une ligne à retard formée par une chaîne de retards (41-1, 41-n) comportant un nombre d'éléments n supérieur d'un montant Max(PN) à la longueur L nécessaire pour couvrir une période entière dudit signal haute fréquence $F_{DCO}$;
- un ensemble de bascules (42-1 à 42-n) permettant chacune de stocker la sortie d'un élément correspondant de ladite chaîne à retard aux fins de génération d'un code thermométrique présentant une succession de « 1 » séparé par une succession de « 0 », la transition entre les « 1 » et les « 0 » correspondant à la transition dudit signal haute fréquence $F_{DCO}$ par rapport à ladite fréquence de référence ;
- des moyens (52) permettant de supprimer de manière aléatoire un nombre PN de bits, ledit nombre PN variant de 0 à MAX(PN) ;
- des moyens de détection de fronts et de décodage thermométrique binaire pour générer des informations numériques $\Delta t_r$ et $\Delta t_f$ respectivement représentatives des décalages des fronts montants et descendants entre ledit signal haute fréquence $F_{DCO}$ et ladite fréquence de référence ;
- des moyens (49) permettant de traiter les informations $\Delta t_r$ et $\Delta t_f$ pour calculer un gain normalisé et générer la valeur moyenne de l'inverse de la période $1/T_{DCO}$ dudit premier signal
- des moyens (51) pour ajouter à $\Delta t_r$ une valeur binaire correspondant au nombre de bits PN supprimés ;
- des moyens (50) pour multiplier le résultats précédents par la valeur moyenne de l'inverse de $1/T_{DCO}$ et générer une valeur numérique $\varepsilon$ représentative de l'écart de phase.

On ne décrira pas plus avant le circuit de synthèse de fréquence car un homme du métier appliquera directement le convertisseur à l'architecture de la figure 1.

Il est à noter toutefois que, dans l'application considérée, à savoir le traitement d'une partie fractionnelle du circuit P.L.L. , le circuit TDC génère une valeur numérique $\varepsilon$ qui est représentative de l'écart de phase entre l'horloge de référence $F_{ref}$ et l'horloge synthétisée $F_{DCO}$. Dans un mode de réalisation le codage utilisé est représentatif du nombre de pas de quantification d'écarts pour la partie fractionnée. Ainsi, pour un code à deux bits, on aura quatre pas de quantification, ce qui permettra de coder les valeurs 0 , 0.25, 050, 075 .

## Revendications

1. Procédé d'ajout d'un bruit aléatoire dans un circuit convertisseur temps-numérique destiné à calculer l'écart de phase entre un premier signal rapide $F_{DCO}$ relativement à un second signal de référence $F_{ref}$ , plus lent, ledit procédé comportant les étapes :

   - traitement (60) du premier signal $F_{DCO}$ au moyen d'une chaîne à retard comportant un ensemble de n retard élémentaires dont le nombre est choisi de manière à couvrir une période complète dudit première signal ;
   - stockage (61) des sorties desdites chaînes à retard dans un ensemble de bascules et génération d'un code thermométrique présentant une succession de « 1 » séparé par une succession de « 0 », la transition entre les « 1 » et les « 0 » correspondant à la transition dudit premier signal par rapport audit second signal de référence ;
   - réduction (62) dudit code thermométrique d'un nombre aléatoire de PN bits
   - traitement (63) du résultat dans un détecteur de front et décodeur thermométrique binaire de manière à générer les variables $\Delta t_r$ et $\Delta t_f$ représentative de l'écart des temps de montée et de descentes dudit premier signal par rapport audit second signal de référence ;
   - calcul du gain normalisé (64) de manière à générer la valeur moyenne de $1/T_{DCO}$
   - ajout (65) d'une valeur binaire correspondant au nombre de bits PN à la valeur $\Delta t_r$
   - multiplication (66) du résultat précédent par la valeur moyenne de $1/T_{DCO}$ et calcul de l'écart de phase entre les signaux

2. Procédé selon la revendication 1 **caractérisé en ce que** ladite chaîne à retard est réalisée au moyen d'inverseurs.

3. Procédé selon la revendication 2 **caractérisé en ce que** ladite chaîne à retard est réalisée au moyen d'éléments tampons (ou suiveurs).

4. Procédé selon la revendication 1 **caractérisé en ce qu'**il est utilisé pour la synthèse d'une fréquence dans un système de communication.

5. Circuit convertisseur de type TDC comportant deux entrées recevant respectivement un premier signal rapide $F_{DCO}$ relativement à un second signal de référence $F_{ref}$, plus lent, et générant en sortie un mot numérique représentatif de l'écart de phase entre les deux signaux ;
   ledit circuit comportant :

   - une ligne à retard formée par une chaîne de retards (41-1, 41-n) comportant un nombre d'éléments n supérieurs d'un montant Max(PN) à la longueur L nécessaire pour couvrir une période entière dudit premier signal ;
   - un ensemble de bascules (42-1 à 42-n) permettant chacune de stocker la sortie d'un élément correspondant de ladite chaîne à retard aux fins de génération d'un code thermométrique présentant une succession de « 1 » séparé par une succession de « 0 », la transition entre les « 1 » et les « 0 » correspondant à la transition dudit premier signal par rapport audit second signal de référence ;
   - des moyens (52) permettant de supprimer de manière aléatoire un nombre PN de bits, ledit nombre PN variant de 0 à MAX(PN) ;
   - des moyens de détection de fronts et de décodage thermométrique binaire pour générer des informations numériques $\Delta t_r$ et $\Delta t_f$ respectivement représentatives des décalages des fronts montants et descendants entre lesdits premiers et second signaux ($F_{ref}$ et $F_{DCO}$);
   - des moyens (49) permettant de traiter les informations $\Delta t_r$ et $\Delta t_f$ pour calculer un gain normalisé et générer la valeur moyenne de l'inverse de la période $1/T_{DCO}$ dudit premier signal
   - des moyens (51) pour ajouter à $\Delta t_r$ une valeur binaire correspondant au nombre de bits PN supprimés ;
   - des moyens (50) pour multiplier le résultats précédents par la valeur moyenne de l'inverse de $1/T_{DCO}$ et générer une valeur numérique ε représentative de l'écart de phase.

6. Circuit selon la revendication 5 **caractérisé en ce que** ladite chaîne à retard est réalisée au moyen d'inverseurs.

7. Circuit selon la revendication 5 **caractérisé en ce que** ladite chaîne à retard est réalisée au moyen d'éléments tampons (ou buffers).

8. Circuit de synthèse de fréquence permet de générer un signal haute fréquence $F_{DCO}$ à partir d'une fréquence de référence $F_{REF}$, comportant :

   - des moyens (9) permettant de générer une fréquence synchrone Fs synchronisée sur ladite fréquence de référence ;
   - une chaîne de traitement numérique comportant, en série, un accumulateur de phase (2), un additionneur (3) générant un signal d'erreur $\Phi_E$,

un filtre de boucle (4) et un oscillateur (5) générant sur une sortie 6 ledit signal haute fréquence $F_{DCO}$ ;
- des moyens d'asservissement en fréquence et en phase dudit signal $F_{DCO}$ comportant une première et une seconde boucle de contre-réaction pour traiter respectivement la partie entière et la partie fractionnée du ratio n souhaité entre la fréquence de sortie $F_{DCO}$ et la fréquence de référence $F_{ref}$

**caractérisé en ce que** le traitement de la partie fractionnée est réalisé au moyen d'un convertisseur temps - numérique tel que défini dans la revendication 5.

9. Circuit de synthèse de fréquence selon la revendication 8 **caractérisé en ce**, ladite première boucle de contre-réaction est basée sur un accumulateur 7 et sa bascule de sous-échantillonnage 8 rythmée par l'horloge interne Fs ;

**Claims**

1. Process for inserting a random noise in a Time to Digital Converter (TDC) designed for calculating the phase error between a first high frequency signal $F_{DCO}$ with respect to a second reference signal $F_{ref}$, switching at a lower frequency, said process including the steps:

    - processing (60) of the first signal $F_{DCO}$ by means of a chain of delays comprising a set of n elementary delays which number is chosen so as to extend over a full period of said first signal ;
    - storing (61) the outputs of said chain of delays in a set of latches and generation of a thermometer code presenting a stream of « 1 » separated from a stream of « 0» by a border corresponding to the transition of said first signal with respect to the second reference signal;
    - reducing (62) said thermometer code by a random number PN of bits ;
    - processing (63) of the result in a edge detecting and binary thermometer code decoding means so as to generate two variables $\Delta t_r$ and $\Delta t_f$ which are representative of the difference between the rise and fall time of said first signal with respect to the second reference signal;
    - computing the normalized gain (64) so as to generate an average value of $1/T_{DCO}$
    - adding (65) to the value $\Delta t_r$ a binary value corresponding to the number of bits PN;
    - multiplying (66) the preceding result by the average value of $1/T_{DCO}$ and computing the phase error between the signals.

2. Process according to claim 1 **characterized in that** said chain of delay comprises inverters.

3. Process according to claim 2 **characterized in that** said delay chain comprises buffers.

4. Process according to claim 1 **characterized in that** it is adapted to synthetize a frequency in a communication system.

5. Time To Digital Converter comprising two inputs respectively receiving a first high frequency signal $F_{DCO}$ and a second reference signal $F_{ref}$, switching at a relatively lower frequency, said convertor generating at its output one digital word representative of the phase difference between the two signals;
said circuit further comprising :

    - a delay line comprising a chain of delays (41-1, 41-n) comprising a number n of elements being Max(PN) higher than the length L required fro covering a full period of said first signal $F_{DCO}$;
    - a set of latches (42-1, 42-n), each allowing the storage of the output of one corresponding element of said chain of delays so as to generate a thermometer code presenting a stream of "1" separated from a stream of "0" by a border corresponding to the transition of said first signal with respect to the said second reference signal;
    - means (52) for cancelling in a random manner a number PN of bits, said number which may vary from 0 to MAX(PN);
    - edge detecting and binary thermometer decoding means for generating digital information $\Delta t_r$ and $\Delta t_f$ which are respectively representative of the difference between the rising edges and the falling edges between said first and second signals ($F_{DCO}$ and $F_{ref}$)
    - means (49) for processing the information $\Delta t_r$ and $\Delta t_f$ so as to compute a normalized gain and generate the average value of the inverse of the period $T_{DCO}$ of said first signal;
    - means (51) for adding to $At_r$ a binary value corresponding to the number of bits PN which was suppressed ;
    - means (50) for multiplying the preceding result by the average value of $1/T_{DCO}$ so as to generate a digital value $\varepsilon$ which is representative of the phase error.

6. Circuit according to claim 5 wherein said chain of delays is arranged with inverters.

7. Circuit according to claim 5 wherein said chain of delays is arranged with buffers

8. Frequency synthesizing circuit for generating a high frequency signal $F_{DCO}$ from a reference frequency $F_{REF}$, comprising:

- means (9) for generating a frequency being synchronous with said reference frequency $F_{REF}$,
- a digital processing chain comprising, in series, one phase accumulator (2), one adder (3) generating an error signal $\Phi_E$, one loop filter (4) and one oscillator (5) generating at its output (6) said high frequency signal $F_{DCO}$ ;
- frequency and phase adaptative control means of said signal $F_{DCO}$ comprising a first and a second control loops for respectively processing the integer part and the fractional part of the desired ratio of the output frequency $F_{DCO}$ to the reference frequency $F_{ref}$;

**characterized in that** the processing of the fractional part is achieved by means of a Time to Digital Converter (TDC) as defined in claim 5.

9. Frequency synthetizing circuit according to claim 8 wherein said first control loop is based on an accumulator (7) having its sampling clock (8) being pulsed by an internal clock (Fs).

**Patentansprüche**

1. Verfahren zum Hinzufügen eines Zufallsrauschens in einem Zeit-Digital-Wandlungsschaltkreis zur Berechnung der Abweichung der Phase zwischen einem ersten schnellen Signal $F_{DCO}$ bezogen auf ein zweites, langsameres Referenzsignal $F_{ref}$, wobei das besagte Verfahren die folgenden Schritte aufweist:

- Verarbeitung (60) des ersten Signals $F_{DCO}$ mit Hilfe einer Verzögerungskette, die eine Gesamtheit von n elementaren Verzögerungen aufweist, deren Anzahl so gewählt wird, dass eine vollständige Periode des besagten ersten Signals abgedeckt wird;
- Speicherung (61) der Ausgänge der besagten Verzögerungsketten in einer Kippschaltung und Erzeugung eines thermometrischen Codes, der eine Abfolge von„ 1-ern" aufweist, getrennt von einer Abfolge von "0-ern", wobei der Übergang zwischen den "1-ern" und den "0-ern" dem Übergang des besagten ersten Signals in Bezug auf das besagte zweite Referenzsignal entspricht;
- Reduktion (62) des besagten thermometrischen Codes um eine Zufallszahl von PN Bits;
- Verarbeitung (63) des Ergebnisses in einem Kantendetektor und einem binärem thermometrischen Dekoder auf eine Weise, dass die Va-

riablen $\Delta t_r$ und $\Delta t_f$ erzeugt werden, die für die Zeitdifferenz zwischen Anstieg und Abfall des besagten ersten Signals in Bezug auf das besagte zweite Referenzsignal repräsentativ sind;
- Berechnung der normalisierten Verstärkung (64) dergestalt, dass ein Mittelwert von $1/T_{DCO}$ berechnet wird;
- Hinzufügen (65) eines binären Wertes, der der Anzahl der Bits PN mit dem Wert $\Delta t_r$ entspricht;
- Multiplikation (66) des vorherigen Ergebnisses mit dem Mittelwert von $1/T_{DCO}$ und Berechnung der Abweichung der Phase zwischen den Signalen.

2. Verfahren gemäß Anspruch 1, **dadurch gekennzeichnet, dass** besagte Verzögerungskette mittels Invertern hergestellt wird.

3. Verfahren gemäß Anspruch 2, **dadurch gekennzeichnet, dass** besagte Verzögerungskette mittels Pufferelementen (oder Verfolgern) hergestellt wird.

4. Verfahren gemäß Anspruch 1, **dadurch gekennzeichnet, dass** es für die Synthese einer Frequenz in einem Kommunikationssystem verwendet wird.

5. Converter-Schaltung vom Typ TDC, welcher zwei Eingänge umfasst, die jeweils ein erstes schnelles Signal $F_{DCO}$ bezogen auf ein zweites, langsameres Referenzsignal $F_{ref}$ empfangen und welcher am Ausgang ein digitales Wort generiert, das für die Abweichung der Phase zwischen den beiden Signalen repräsentativ ist; wobei besagte Schaltung Folgendes umfasst:

- eine Verzögerungsleitung, gebildet von einer Verzögerungskette (41-1, 41-n), die eine Anzahl von Elementen n umfasst, die über einem Betrag Max(PN) mit der Länge L liegt, die zur Abdeckung einer gesamten Periode des besagten ersten Signals erforderlich ist;
- eine Kippschaltung (42-1 bis 42-n), die jeweils die Speicherung des Ausgangs eines der besagten Verzögerungskette entsprechenden Elements zwecks Generation eines thermometrischen Codes ermöglicht, der eine Abfolge von "1-ern" aufweist, getrennt von einer Abfolge von "0-ern", wobei der Übergang zwischen den "1-ern" und den "0-ern" dem Übergang des besagten ersten Signals in Bezug auf das besagte zweite Referenzsignal entspricht;
- Mittel (52), welche die zufallsgesteuerte Löschung einer Anzahl von Bits PN ermöglichen, wobei besagte Anzahl PN von 0 bis MAX(PN) variiert;
- Mittel zur Erkennung von Kanten und zur binären thermometrischen Dekodierung zur Erzeugung der digitalen Daten $\Delta t_r$ und $\Delta t_f$, die je-

weils für die Verschiebungen der ansteigenden und abfallenden Kanten zwischen den besagten ersten und zweiten Signalen ($F_{ref}$ und $F_{DCO}$) repräsentativ sind;

- Mittel (49), welche die Verarbeitung der Daten $\Delta t_r$ und $At_f$ ermöglichten, um eine normalisierte Verstärkung zu berechnen und den Mittelwert der Inversion der Periode $1/T_{DCO}$ des besagten ersten Signals zu erzeugen;

- Mittel (51), um zu $\Delta t_r$ einen binären Wert hinzuzufügen, welcher der Anzahl der gelöschten Bits PN entspricht;

- Mittel (50) zur Multiplikation der vorherigen Ergebnisse mit dem Mittelwert der Inversion von $1/T_{DCO}$ und zur Erzeugung eines digitalen Wertes $\varepsilon$, der für die Abweichung der Phase repräsentativ ist.

6. Schaltung gemäß Anspruch 5, **dadurch gekennzeichnet, dass** besagte Verzögerungskette mittels Invertern hergestellt wird.

7. Schaltung gemäß Anspruch 5, **dadurch gekennzeichnet, dass** besagte Verzögerungskette mittels Pufferelementen (oder Buffern) hergestellt wird.

8. Frequenzsyntheseschaltung, die die Erzeugung eines Hochfrequenzsignals $F_{DCO}$ aus einer Referenzfrequenz $F_{REF}$ ermöglicht, die Folgendes umfasst:

    - Mittel (9) zur Erzeugung einer synchronen Frequenz Fs, die auf besagter Referenzfrequenz synchronisiert ist;
    - eine digitale Verarbeitungskette, in Reihe, umfassend einen Phasenakkumulator (2), einen Addierer (3), der ein Fehlersignal $\Phi_E$ erzeugt, ein Schleifenfilter (4) und einen Oszillator (5), der am Ausgang 6 besagtes Hochfrequenzsignal $F_{DCO}$ erzeugt;
    - Mittel zur Steuerung der Frequenz und der Phase des besagten Signals $F_{DCO}$, die eine erste und eine zweite Rückkopplungsschleife aufweisen für die jeweilige Verarbeitung des gesamten Abschnitts und des Teilabschnitts des gewünschten Quotienten n aus der Ausgangsfrequenz $F_{DCO}$ und der Referenzfrequenz $F_{ref}$,

    **dadurch gekennzeichnet, dass** die Verarbeitung des Teilabschnitts mit Hilfe eines digitalen Zeitwandlers erfolgt, wie in Anspruch 5 definiert.

9. Frequenzsyntheseschaltung gemäß Anspruch 8, **dadurch gekennzeichnet, dass** die besagte erste Rückkopplungsschleife auf einem Akkumulator 7 und ihrer Kippstufe der Unterabtastung 8 basiert, getaktet durch die interne Uhr Fs.

# Fig. 1

# Fig. 2

Fig. 3

Fig. 4

Erreur de phase positive

$$F_{REF}$$

$$F_{DCO}$$

$\Phi_E > 0$    $\epsilon = 1 - \Delta t_R/T_{DCO}$

Erreur de phase négative

$$F_{REF}$$

$$F_{DCO}$$

$T_{DCO}/2$    $|\Phi_E < 0|$    $\epsilon = 1 - \Delta t_R/T_{DCO}$

# Fig. 5

```
Traitement dans une chaîne à retard
```
60

```
Construction d'un vecteur en code T
```
61

```
réduction de PN bits du code T
```
62

```
traitement par détecteur de fronts
```
63

```
calcul du gain normalisé 1/Tdco
```
64

```
Ajout de PN à DELTA Tr
```
65

```
Calcul de l'écart de phase
```
66

# Fig. 6

Sans dispersion     Avec dispersion

Sortie
normalisée

Linéarité

Unité de temps normalisé Tx/ Tdco

# Fig. 7a

Sortie du TDC avec dispersion/ sans dispersion

Sortie normalisée
(epsilon)

Idéal
Dispersion
sans disp

Epsilon (avec disp)
- epsilon (sans disp)

Unité de temps normalisé Tx/ Tdco

# Fig. 7b

Fig. 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 306655 A

- US 2006103566 A1

**Littérature non-brevet citée dans la description**

- **de Staszewski et al.** All-Digital Phase-Domain TX Frequency Synthesizer for Bluetooth Radios in 0.13pm CMIOS. *IEEE INTERNATIONAL SOLID STATE CIRCUITS CONFERENCE,* 2004, vol. 15, 272-273